# FASCICULE DE BREVET EUROPEEN

(11) **EP 2 074 695 B1**
(45) Date de publication et mention de la délivrance du brevet: **07.07.2010**
(21) Numéro de dépôt: 07821014.3
(22) Date de dépôt: 08.10.2007
(51) Int. Cl.: H03H 9/21

(54) **RESONATEUR EN SILICIUM DE TYPE DIAPASON**
SILIZIUMRESONATOR DES STIMMGABELTYPS
SILICON RESONATOR OF THE TUNING-FORK TYPE

(30) Priorité: 09.10.2006 CH 16062006
(43) Date de publication de la demande: 01.07.2009
(73) Titulaire: CSEM Centre Suisse d'Electronique et de Microtechnique SA, 2002 Neuchâtel (CH)
(72) Inventeur: BABOROWSKI, Jacek, CH-1307 Lussery Villars (CH); BOURGEOIS, Claude, CH-2014 Bôle (CH); DUBOIS, Marc-Alexandre, CH-1143 Apples (CH); RUFFIEUX, David, CH-1789 Lugnorre (CH)
(74) Mandataire: GLN
(86) Numéro de dépôt international: PCT/EP2007/060641
(87) Numéro de publication internationale: WO 2008/043727

(56) Documents cités:
- JP-A- 57 183 116
- JP-A- 58 003 411
- JP-A- 59 171 303
- ANONYMOUS: "Temperature Compensation for Constant Frequency Electrochemical Oscillators. September 1971." IBM TECHNICAL DISCLOSURE BULLETIN, vol. 14, no. 4, 1 septembre 1971 (1971-09-01), pages 1237-1238, XP002462194 New York, US
- ESASHI M ET AL: "Packaged micromechanical sensors" EMERGING TECHNOLOGIES AND FACTORY AUTOMATION, 1994. ETFA '94., IEEE SYMPOSIUM ON TOKYO, JAPAN 6-10 NOV. 1994, NEW YORK, NY, USA,IEEE, 6 novembre 1994 (1994-11-06), pages 30-37, XP010139977 ISBN: 0-7803-2114-6
- HRIBSEK M F: "Electromechanical silicon beam filter bank" MICROELECTRONICS JOURNAL, MACKINTOSH PUBLICATIONS LTD. LUTON, GB, vol. 27, no. 6, septembre 1996 (1996-09), pages 525-530, XP004007231 ISSN: 0026-2692
- BOURGEOIS C ET AL: "Design of resonators for the determination of the temperature coefficients of elastic constants of monocrystalline silicon" FREQUENCY CONTROL SYMPOSIUM, 1997., PROCEEDINGS OF THE 1997 IEEE INTERNATIONAL ORLANDO, FL, USA 28-30 MAY 1997, NEW YORK, NY, USA,IEEE, US, 28 mai 1997 (1997-05-28), pages 791-799, XP010257368 ISBN: 0-7803-3728-X
- ABE M ET AL: "Trident-type tuning fork silicon gyroscope by the phase difference detection" IEEE, 23 janvier 2000 (2000-01-23), pages 508-513, XP010377179

## Description

### Domaine technique

L'invention concerne un résonateur en silicium de type diapason. Elle concerne plus particulièrement un résonateur de ce type dont la dérive linéaire de la fréquence en fonction de la température est compensée.

Il existe actuellement une forte demande pour des structures résonantes (résonateurs acoustiques, capteurs, structures oscillantes) réalisées en silicium à cause de leur compatibilité avec les circuits intégrés et de leur capacité de miniaturisation. De nombreuses solutions ont été jusqu'à présent proposées qui font appel à différents types de géométrie de résonateur et à différents modes d'actuation.

Dans les structures connues de résonateurs MEMS (Micro-Electro-Mechanical System), l'activation est le plus souvent réalisée par un couplage électrostatique, lequel nécessite des tensions, qu'elles soient continues ou alternatives, relativement élevées. Le principal inconvénient des résonateurs connus est que, du fait de l'importance de la dérive thermique intrinsèque du silicium, le comportement de ces MEMS est très dépendant de la température de fonctionnement de ces dispositifs. Pour bon nombre d'applications, ce comportement n'est pas acceptable et doit être compensé d'une manière ou d'une autre.

### Etat de la technique

La littérature mentionne divers types de compensation thermique comprenant, entre autres, la compensation réalisée au niveau de l'oscillateur sur la base de l'information fournie par un thermomètre intégré. Cette méthode nécessite un étalonnage individuel des dispositifs et, outre la lourdeur du procédé, la stabilité de la compensation thermique est directement liée à la stabilité du thermomètre intégré laquelle, parfois, ne satisfait pas aux exigences requises. De plus, avec ce type de compensation, la plage de tirage de la fréquence du résonateur est le plus souvent trop limitée pour les applications envisagées. D'autres méthodes proposent d'agir sur les contraintes internes aux résonateurs (« Mechanically Temperature-Compensated Flexural-Mode Micromechanichal Resonators », Wan-Thai Hsu et al., IEEE 2000), de modifier la rigidité du substrat (« Stiffness-Compensated Temperature-Insensitive Micromechanical Resonators », Wan-Thai Hsu et al., IEEE 2002) ou, encore, d'ajuster la température de fonctionnement du résonateur (« Active Temperature Compensation for Micromachined Resonators », M. Hopcroft et al., Solid-State Sensor, Actuator and Microsystems Workshop, Hilton Head Island, South Carolina, June 6-10, 2004).

Toutefois, les résonateurs obtenus selon ces méthodes ne satisfont pas à l'ensemble des critères de faible encombrement, faible coût, faible consommation et facilité de fabrication.

De plus, on connaît du document WO 98/29943 la possibilité d'utiliser un résonateur présentant une structure composite à base de silicium, permettant de compenser sa dérive thermique. Le résonateur proposé est un film comprenant une première couche en silicium et au moins une deuxième couche en oxyde ou en nitrure de silicium. Le film est tendu par ses deux extrémités à des supports. La différence de dilatation entre les deux matériaux utilisés fait que, lorsque le résonateur subit un changement de température, la tension du résonateur entre les deux supports varie, de sorte que la fréquence de résonance du résonateur est sensiblement stable en fonction de la température. De fait, cette méthode implique nécessairement que les deux extrémités du résonateur soient fixées afin de pouvoir, à la manière d'une corde de guitare, faire varier sa tension.

### Divulgation de l'invention

Pour résoudre ces problèmes, l'invention propose un résonateur du type décrit précédemment comportant une base ou socle en silicium, une pluralité de bras parallèles s'étendant à partir du socle et capables d'entrer en vibration, et des moyens d'actuation pour exciter la vibration des bras, le résonateur étant **caractérisé en ce que** lesdits bras comprennent, dans le sens de leur épaisseur, une couche de silicium et, au moins, une couche d'oxyde de silicium dont l'épaisseur, par rapport à celle de la couche de silicium, est telle qu'elle permet de compenser, au premier ordre, la dérive thermique du résonateur.

Selon d'autres caractéristiques de l'invention :
- la couche de silicium est comprise entre deux couches d'oxyde de silicium ;
- les moyens d'actuation comprennent une couche piézoélectrique déposée sur au moins une partie des bras ;
- la couche piézoélectrique est en nitrure d'aluminium ;
- les bras sont au nombre de 3, le bras intérieur étant deux fois plus large environ que les bras extérieurs ;
- les bras sont mis en vibration selon un mode de flexion hors du plan les bras extérieurs vibrant en opposition de phase par rapport au bras central ;
- le mode de flexion est couplé à un mode d'allongement dans le plan ;
- les moyens d'actuation sont de type électrostatique ;
- le mode de vibration est un mode de flexion dans le plan.

L'invention concerne également des procédés permettant de réaliser des résonateurs selon l'invention.

### Brève description du dessin

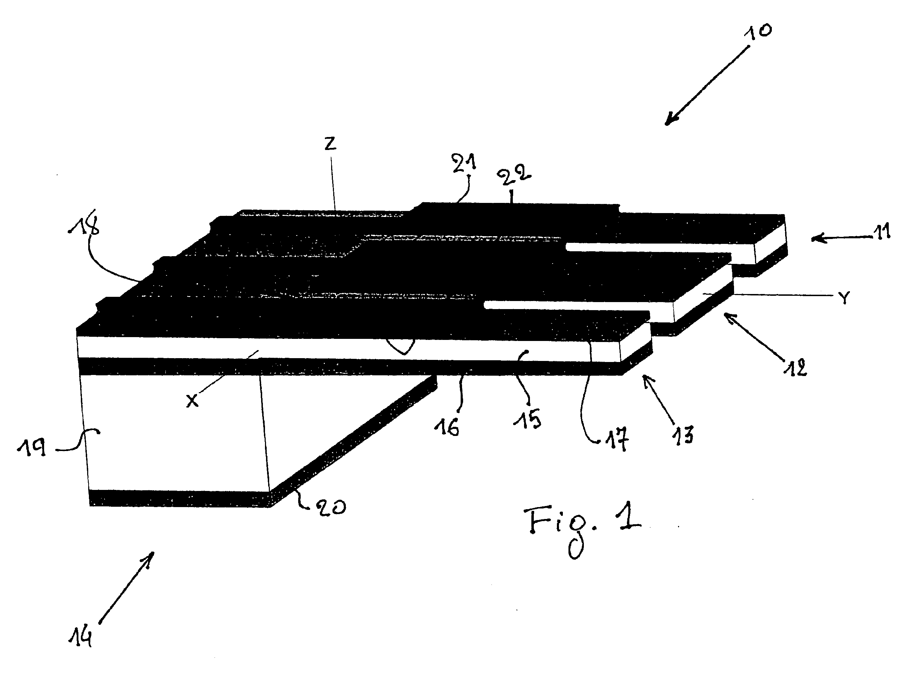

D'autres caractéristiques et avantages de l'invention apparaîtront au cours de la lecture de la description détaillée qui va suivre pour la compréhension de laquelle on se reportera à la figure 1 annexée qui est une vue en perspective qui représente un résonateur en forme de diapason à trois bras réalisé selon les enseignements de l'invention.

### Mode(s) de réalisation de l'invention

Pour la suite de la description, on adoptera des orientations transversale "X" et longitudinale "Y" ainsi qu'un axe normal "Z" perpendiculaire aux orientations longitudinale et transversale. Ces orientations sont indiquées, respectivement, par les axes "X, Y, Z" de la figure 1.

On a représenté, à la figure 1, un résonateur 10 qui comporte trois bras susceptibles d'être mis en vibration par l'intermédiaire de couches de nitrure d'aluminium (AIN) disposées sur leurs faces supérieures.

Le résonateur 10 a la forme d'un diapason à trois bras qui comporte une base ou socle 14 à partir duquel s'étendent trois bras parallèles 11, 12 et 13. Le socle 14 lui-même est, en grande partie, en silicium 19. Sur sa face supérieure, il présente la même structure que celle des bras et, sur sa face inférieure, il peut montrer une couche d'oxyde de silicium (SiO₂) due au procédé.

Chacun des bras présente une partie centrale 15 en silicium prise entre deux couches 16 et 17 d'oxyde de silicium (SiO₂). Selon une variante de l'invention, les bras ne comportent qu'une partie en silicium et une seule couche d'oxyde réalisée sur la face inférieure ou supérieure de la partie en silicium.

Chacun des bras comporte, en outre, une couche piézoélectrique 18, déposée sur une partie de leur longueur proche du socle et réalisée en nitrure d'aluminium, cette couche permettant l'excitation des bras par des moyens électroniques bien connus de l'homme de l'art. Comme le nitrure d'aluminium est quatre fois plus rigide que l'oxyde de silicium, il est préférable que la couche d'AIN n'occupe qu'une très faible partie des bras susceptibles d'entrer en vibration. Pour pouvoir être excitée, la couche d'AIN est prise entre deux électrodes, l'une inférieure 21 sur la couche de SiO₂ 17 et l'autre supérieure 22 sur la couche d'AIN.

Le bras central a une largeur égale à environ 2 fois celle des bras extérieurs.

L'excitation des bras est faite de telle sorte que les bras vibrent en flexion hors du plan (X-Y) formé par ces derniers au repos et que les vibrations des bras extérieurs soient en opposition de phase avec celle du bras intérieur. De cette façon, le déplacement des masses se compense, ce qui rend le résonateur moins sensible aux effets d'accélération et augmente son facteur de qualité.

Sur les résonateurs réalisés, on a observé que le mode de vibration en flexion hors du plan est couplé avec un mode d'allongement des bras dans le plan (X-Y). Comme ce dernier mode a une fréquence de vibration nettement plus élevée que le mode de vibration en flexion, il est facilement éliminé par l'oscillateur auquel le résonateur est connecté en fonctionnement.

L'épaisseur de la couche de SiO₂ sur chacun des bras par rapport à celle de la couche de Si est telle qu'elle permet d'annuler le premier ordre de la dérive thermique. En effet, les dérives du Si et du SiO₂ en fonction de la température agissent de manière opposée. Plus précisément, les premiers coefficients thermiques de la rigidité de ces deux matériaux sont de signes inverses. De la sorte, un changement de température donné induit une certaine variation de rigidité de la couche de Si et une variation en sens inverse de la rigidité de la couche de SiO₂. L'épaisseur relative des couches de Si et de SiO₂ permet que les variations de rigidité des deux couches se compensent. Ainsi et à titre d'exemple, pour une épaisseur de Si de 25 microns, une épaisseur de 5 microns de SiO₂ sur chaque face du bras permet déjà d'annuler la dérive linéaire ou, au moins, de la réduire très fortement. On a pu ainsi déjà montrer qu'elle pouvait être réduite à moins de 1 ppm (parties par million ou 10⁻⁶) par degré. De manière évidente, si, pour obtenir un même effet, le bras ne comporte qu'une seule couche de SiO₂ située sous ou sur la couche de silicium, son épaisseur sera d'environ plus importante que dans le cas où le bras comporte deux couches.

Une compensation du deuxième et troisième ordre de la dérive thermique peut être faite, si nécessaire, par des moyens conventionnels, par exemple, par voie électronique.

La fréquence de résonance est fixée, principalement, par les dimensions du résonateur et peut être fixée facilement dans une gamme de quelques dizaines à quelques centaines de kHz, voire à plusieurs MHz.

A titre d'exemple, un résonateur vibrant à 32 kHz a une longueur de 1.2 mm et une largeur hors tout d'environ 1 mm. La largeur des bras est de 200 et 400 microns, respectivement, leur épaisseur de 25 microns. La distance entre les bras est de 50 microns. Le socle a une épaisseur de 380 microns.

La fabrication de résonateurs tels que principalement décrits ci-dessus, se fait à partir de plaquettes de silicium sur isolant (SOI, de l'anglais Silicium On Insulator) qui ont une base épaisse en silicium, comportant une couche mince de SiO₂ sur laquelle a été réalisée une couche mince de silicium. Les couches minces de SiO₂ et de silicium ont les épaisseurs requises pour la réalisation des bras du résonateur.

Le terme épais qualifiant la base est essentiellement relatif par rapport aux couches minces de SiO₂ et de silicium. En pratique, l'épaisseur de la base est suffisante pour permettre la réalisation du socle du résonateur, c'est-à-dire pour que celui-ci soit particulièrement rigide afin de permettre une meilleure évanescence des modes de vibration et, par suite, d'atteindre un facteur de qualité élevé.

Par rapport aux axes cristallographiques de la plaquette, l'axe longitudinal du résonateur 10 sera orienté selon l'une des directions <100> ou <110>, cette dernière orientation étant cependant préférée.

La première étape est une étape d'oxydation de la plaquette sur ses deux faces. Ces couches d'oxyde (SiO₂) forment l'une, la couche supérieure 17 des bras et l'autre, la couche 20 du socle 14.

Après l'oxydation, on forme les moyens d'actuation des bras. Une couche de métal, par exemple de platine (Pt), est déposée, par pulvérisation ou évaporation, sur toute la couche supérieure de SiO₂ puis structurée de manière à prendre la forme du résonateur. Le platine a été choisi car ce métal garantit une orientation cristallographique optimale de l'AIN.

L'étape suivante est le dépôt de la couche d'AIN par pulvérisation puis, sur cette couche est déposée l'électrode supérieure, laquelle peut être en Pt, Al, AlSi, etc. Cette électrode supérieure est ensuite structurée pour correspondre à la zone d'actuation. Une ouverture est réalisée dans la couche d'AIN afin de pouvoir établir un contact électrique avec l'électrode inférieure.

La forme du résonateur est ensuite définie à l'aide d'une gravure plasma. Ensuite, la face arrière de la plaquette est attaquée, également par plasma, pour éliminer le silicium sous les bras. L'attaque s'arrête au niveau des couches minces de SiO₂.

Les bras sont ensuite dégagés par attaque du silicium et du SiO₂ entre les bras.

Selon une variante moins performante mais néanmoins réalisable, le SOI de départ du procédé de réalisation ci-dessus peut n'être oxydé qu'au niveau de sa face inférieure, c'est-à-dire sur sa face définie par la base épaisse en silicium. En pratique, il peut être préférable d'oxyder le SOI sur ses deux faces et d'enlever la couche supérieure de SiO₂, c'est-à-dire celle située du côté de la couche mince de silicium.

Puis, comme décrit pour le procédé de réalisation ci-dessus, les moyens d'actuation des bras sont formés, en déposant sur la face supérieure de la plaquette, située du côté de la couche mince de silicium, une couche piézoélectrique entre deux électrodes.

Enfin, l'ensemble obtenu est gravé pour lui donner la forme du résonateur et pour former les bras. On notera que, au niveau des bras, la gravure est arrêtée du côté de la face inférieure de la plaquette, à la couche mince de SiO₂. Les bras comportent ainsi une couche inférieure de SiO₂ et une couche supérieure de silicium portant les moyens d'actuation.

Dans une autre variante du procédé de réalisation, on part d'un wafer simple épais, c'est-à-dire dont l'épaisseur est suffisante pour réaliser le socle du résonateur. La plaquette est oxydée sur ses deux faces de manière à former une couche de SiO₂ supérieure et une couche de SiO₂ inférieure.

Puis, comme décrit pour le procédé de réalisation ci-dessus, les moyens d'actuation des bras sont formés, en déposant sur l'une des faces de la plaquette, une couche piézoélectrique entre deux électrodes.

Enfin, l'ensemble obtenu est gravé pour lui donner la forme du résonateur et pour former les bras. On notera que, au niveau des bras, du côté de la face inférieure ne comportant pas la couche piézoélectrique, la gravure est arrêtée dans le wafer, de manière à former une couche mince de silicium. Les bras comportent ainsi une couche inférieure de silicium et une couche supérieure de SiO₂ portant les moyens d'actuation.

De manière générale, on notera que la couche inférieure de SiO₂, c'est-à-dire celle ne portant pas les moyens d'actuation, n'est pas indispensable.

Bien que l'on ait décrit un résonateur à 3 bras, on peut envisager un nombre de bras supérieur à 3, par exemple, 4, 5 etc. Avec 4 bras, les deux bras centraux seront en phase l'un par rapport à l'autre et en opposition de phase par rapport aux bras extérieurs.

Le mode de vibration préférentiel est le mode de flexion hors du plan; celui-ci est le mode le plus facile à exciter et ne requiert donc qu'une faible épaisseur de la couche piézoélectrique d'AIN. Ce mode de flexion est aussi le mode le plus bas en fréquence et, par conséquent, le mode le moins perturbé par les autres modes. Toutefois, d'autres modes peuvent être utilisés, tel qu'un mode de flexion dans le plan (selon la direction X) des bras externes ou encore un mode d'allongement des bras. La forme des électrodes sera alors adaptée au mode de vibration choisi. On a vu précédemment que ce mode était couplé au mode de flexion hors du plan mais la sélection du mode d'allongement dépendra de l'oscillateur utilisé.

Enfin, le résonateur de l'invention peut être excité non plus par le biais d'une couche piézoélectrique mais par une actuation de type électrostatique. Cette dernière n'est pas préférée car plus difficile à mettre en oeuvre; les distances entre électrodes doivent être soigneusement contrôlées et, selon les réalisations, on peut être confronté à des problèmes de collage (ou "sticking" en anglais).

L'utilisation de plaquettes en silicium (SOI) permet d'envisager la réalisation sur la même puce du résonateur et de son électronique. En effet, le procédé de fabrication du résonateur est à relativement basse température et est compatible avec les procédés de la microélectronique.

## Revendications

1. Résonateur (10) de type diapason en silicium comportant :
- une base ou socle (14),
- trois bras parallèles (11, 12, 13), s'étendant à partir du socle et capables d'entrer en vibration, le bras intérieur étant environ deux fois plus large que les bras extérieurs,
- des moyens d'actuation (18, 21, 22) pour exciter la vibration desdits bras,
**caractérisé en ce que** ladite base ou socle (14) est en silicium et **en ce que** lesdits bras comprennent, dans le sens de leur épaisseur, une couche de silicium (15) et, au moins une couche (16 ou 17) d'oxyde de silicium dont l'épaisseur, par rapport à celle de la couche de silicium, est telle qu'elle permet de compenser, au premier ordre, la dérive thermique du résonateur.

2. Résonateur selon la revendication 1, **caractérisé en ce que** ladite couche de silicium (15) est comprise entre deux couches (16, 17) d'oxyde de silicium.

3. Résonateur selon la revendication 1 ou la revendication 2, **caractérisé en ce que** les moyens d'actuation comprennent une couche piézoélectrique déposée sur au moins une partie des bras, ladite couche piézoélectrique étant comprise entre deux électrodes.

4. Résonateur selon la revendication 3, **caractérisé en ce que** ladite couche piézoélectrique est en nitrure d'aluminium.

5. Résonateur selon l'une des revendications précédentes, **caractérisé en ce que** le mode de vibration des bras est un mode de flexion hors du plan et **en ce que** les bras extérieurs vibrent en opposition de phase par rapport au bras central.

6. Résonateur selon la revendication 1 ou la revendication 2, **caractérisé en ce que** lesdits moyens d'actuation sont du type électrostatique.

7. Résonateur selon l'une des revendications précédentes, **caractérisé en ce que** le mode de vibration est un mode de flexion dans le plan.

8. Procédé de compensation au premier ordre de la dérive thermique d'un résonateur selon l'une des revendications 1 à 7 :
comprenant la disposition d'une couche de silicium (15) et, d'au moins une couche (16 ou 17) d'oxyde de silicium sur lesdits bras, dans le sens de leur épaisseur, l'épaisseur desdites couches de silicium et d'oxyde de silicium, par rapport à celle de la couche de silicium, étant telle qu'elle permet de compenser, au premier ordre, la dérive thermique du résonateur.

9. Procédé selon la revendication 8, **caractérisé en ce que** ladite couche de silicium (15) est comprise entre deux couches (16, 17) d'oxyde de silicium.

10. Procédé de réalisation d'un résonateur (10) selon l'une des revendications 1 à 7, **caractérisé en ce qu'**il consiste à réaliser les bras de manière à ce que ceux-ci comportent une couche de silicium (15), et une couche de Si02 (17) disposée sur les bras et/ou une couche de Si02 (16) disposée sous les bras, les épaisseurs de la couche de silicium et de la ou des couches de Si02 étant déterminées de manière à compenser la dérive thermique au premier ordre du résonateur.

11. Procédé selon la revendication 10, **caractérisé en ce qu'**il comporte les étapes de:
i. se doter d'une plaquette comportant une base épaisse en silicium (19), une couche mince de SiO₂ (16) disposée sur la couche épaisse et sur laquelle a été réalisée une couche mince de silicium (15), les couches minces de SiO₂ et de silicium ayant les épaisseurs requises pour la réalisation desdits bras,
ii. oxyder la plaquette au moins sur sa face supérieure, située du côté de la couche mince de silicium de manière à former une couche de SiO₂ (17) supérieure,
iii. déposer sur la face supérieure de la plaquette, une couche piézoélectrique entre deux électrodes, pour former les moyens d'actuation, et
iv. graver l'ensemble obtenu pour lui donner la forme du résonateur et pour former les bras, la gravure étant arrêtée du côté de la face inférieure de la plaquette, au niveau des bras, à ladite couche mince de SiO₂ (16).

12. Procédé selon la revendication 10, **caractérisé en ce qu'**il comporte les étapes de:
i. se doter d'un wafer épais en silicium,
ii. oxyder la plaquette au moins sur une de ses deux faces de manière à former une couche de SiO₂ (17),
iii. déposer sur la couche de SiO₂ une couche piézoélectrique entre deux électrodes, pour former les moyens d'actuation,
iv. graver l'ensemble obtenu pour lui donner la forme du résonateur et pour former les bras, la gravure étant arrêtée du côté de la face ne comportant pas la couche piézoélectrique, au niveau des bras, de manière à former une couche mince de silicium.

## Claims

1. Resonator (10) of the tuning-fork type in silicon including:
- a stand or base (14),
- three parallel arms (11, 12, 13) extending from the base and capable of vibrating, the inner arm being about twice as wide as the outer arms,
- actuation means (18, 21, 22) for exciting the vibration of said arms,
**characterized in that** said stand or base (14) is made in silicon and **in that** said arms comprise in the direction of their thickness, a silicon layer (15) and at least one layer (16 or 17) of silicon oxide, the thickness of which, relatively to that of the silicon layer, is such that it allows first order compensation of the thermal drift of the resonator.

2. Resonator according to claim 1, **characterized in that** said silicon layer (15) is comprised between two silicon oxide layers (16, 17).

3. Resonator according to claim 1 or claim 2, **characterized in that** the actuation means comprise a piezoelectric layer deposited on at least one portion of the arms, said piezoelectric layer being comprised between two electrodes.

4. Resonator according to claim 3, **characterized in that** said piezoelectric layer is in aluminum nitride.

5. Resonator according one of the preceding claims, **characterized in that** the vibration of the arms is an out-of-plane flexural mode and the outer arms vibrate in phase opposition relatively to the central arm.

6. Resonator according to claim 1 or claim 2, **characterized in that** said actuation means are of the electrostatic type.

7. Resonator according to one of the preceding claims, **characterized in that** the vibration mode is an in-plane flexural mode.

8. Method for first order compensation of the thermal drift of a resonator according to one of claims 1 to 7, comprising the arrangement of a silicon layer (15) and of at least one silicon oxide layer (16 or 17) on said arm, in the direction of their thickness, the thickness of said silicon and silicon oxide layers relatively to the silicon layer being such that it allows first order compensation of the thermal drift of the resonator.

9. Method according to claim 8, **characterized in that** said silicon layer (15) is comprised between two silicon layers (16, 17).

10. Method for making a resonator (10) according to one of claims 1 to 7, **characterized in that** it consists of making the arms so that the latter include a silicon layer (15) and an SiO₂ layer (17) positioned on the arms and/or an SiO₂ layer (16) positioned under the arms, the thicknesses of the silicon layer and of the SiO₂ layer(s) being determined for first order compensation of the thermal drift of the resonator.

11. Method according to claim 10, **characterized in that** it includes the steps of:
i. providing a wafer including a thick silicon base (19), a thin SiO₂ layer (16) positioned on the thick layer and on which a thin silicon layer (15) is made, the thin SiO₂ and silicon layers having the required thicknesses for making said arms,
ii. oxidizing the wafer on at least its upper face, located on the side of the thin silicon layer so as to form an upper SiO₂ layer (17),
iii. depositing on the upper face of the wafer, a piezoelectric layer between two electrodes in order to form the actuation means, and
iv. etching the obtained assembly in order to give it the shape of the resonator and to form the arms, etching being stopped on the side of the lower face of the wafer at the arms, at said thin SiO₂ layer (16).

12. Method according to claim 10, **characterized in that** it includes the steps of:
i. providing a thick silicon wafer,
ii. oxidizing the wafer on at least one of both of its faces so as to form an SiO₂ layer (17),
iii. depositing on the SiO₂ layer a piezoelectric layer between two electrodes in order to form the actuation means,
iv. etching the obtained assembly in order to give it the shape of the resonator and to form the arms, etching being stopped on the side of the face not including the piezoelectric layer, at the arms so as to form a thin silicon layer.

## Patentansprüche

1. Resonator (10) vom Typ Stimmgabel aus Silizium, umfassend:
- eine Basis oder einen Sockel (14) aus Silizium,
- drei parallele Arme (11, 12, 13), die sich ausgehend vom Sockel erstrecken und zu Vibrationen imstande sind, wobei der innere Arm etwa zweimal breiter ist als die äußeren Arme,
- Betätigungsmittel (18, 21, 22), um die Arme in Vibration zu versetzen, **dadurch gekennzeichnet, dass** die Basis oder der Sockel (14) aus Silizium ist und dass die Arme in Richtung ihrer Dicke eine Siliziumschicht (15) und mindestens eine Siliziumoxidschicht (16 oder 17) umfassen, deren Dicke im Verhältnis zur Dicke der Siliziumschicht derart ist, dass sie erlaubt, in erster Ordnung die Wärmedrift des Resonators zu kompensieren.

2. Resonator nach Anspruch 1, **dadurch gekennzeichnet, dass** die Siliziumschicht (15) zwischen zwei Siliziumoxidschichten (16, 17) eingeschlossen ist.

3. Resonator nach Anspruch 1 oder Anspruch 2, **dadurch gekennzeichnet, dass** die Betätigungsmittel eine piezoelektrische Schicht umfassen, die auf mindestens einem Abschnitt der Arme aufgebracht ist, wobei die piezoelektrische Schicht zwischen zwei Elektroden eingeschlossen ist.

4. Resonator nach Anspruch 3, **dadurch gekennzeichnet, dass** die piezoelektrische Schickt aus Aluminium-Nitrid ist.

5. Resonator nach einem der vorangehenden Ansprüche, **dadurch gekennzeichnet, dass** die Vibrationsart der Arme eine Biegungsart außerhalb der Ebene ist und dass die äußeren Arme gegenphasig im Verhältnis zum mittleren Arm vibrieren.

6. Resonator nach Anspruch 1 oder Anspruch 2, **dadurch gekennzeichnet, dass** die Betätigungsmittel elektrostatischen Typs sind.

7. Resonator nach einem der vorangehenden Ansprüche, **dadurch gekennzeichnet, dass** die Vibrationsart eine Biegungsart in der Ebene ist.

8. Kompensationsverfahren in erster Ordnung der Wärmedrift eines Resonators nach einem der Ansprüche 1 bis 7:
die Anordnung einer Siliziumschicht (15) und mindestens eine Siliziumoxidschicht (16 oder 17) auf den Armen in Richtung ihrer Dicke umfassend, wobei die Dicke der Silizium- und Siliziumdioxidschichten im Verhältnis zur Dicke der Siliziumschicht derart ist, dass sie erlaubt, in erster Ordnung die Wärmedrift des Resonators zu kompensieren.

9. Verfahren nach Anspruch 8, **dadurch gekennzeichnet, dass** die Siliziumschicht (15) zwischen zwei Siliziumoxidschichten (16, 17) eingeschlossen ist.

10. Verfahren zur Herstellung eines Resonators (10) nach einem der Ansprüche 1 bis 7, **dadurch gekennzeichnet, dass** es darin besteht, die Arme derart herzustellen, dass diese eine Siliziumschicht (15) und eine auf den Armen angeordnete SiO₂-Schicht (17) und/oder eine unter den Armen angeordnete SiO₂-Schicht (16) aufweisen, wobei die Dicken der Siliziumschicht und der SiO₂-Schicht(en) derart bestimmt sind, um die Wärmedrift in erster Ordnung des Resonators zu kompensieren.

11. Verfahren nach Anspruch 10, **dadurch gekennzeichnet, dass** es die Schritte umfasst:
i. sich ausstatten mit einer Platte, die eine dicke Siliziumbasis (19), eine auf der dicken Schicht angeordnete dünne SiO₂-Schicht (16) aufweisen und auf der eine dünne Siliziumschicht (15) durchgeführt wurde, wobei die dünnen SiO₂- und Siliziumschichten die zur Herstellung der Arme erforderlichen Dicken haben,
ii. Oxidieren der Platte mindestens auf ihrer oberen Fläche, die sich auf der Seite der dünnen Siliziumschicht befindet, derart, dass eine obere SiO₂-Schicht (17) gebildet wird,
iii. Aufbringen auf der oberen Fläche der Platte einer piezoelektrischen Schicht zwischen zwei Elektroden, um die Betätigungsmittel zu bilden, und
iv. Ätzen der entstandenen Einheit, um ihr die Form des Resonators zu geben und um die Arme zu formen, wobei die Ätzung auf der Seite der unteren Fläche der Platte auf Ebene der Arme auf der dünnen SiO₂-Schicht (16) angehalten wird.

12. Verfahren nach Anspruch 10, **dadurch gekennzeichnet, dass** es die Schritte umfasst:
i. sich ausstatten mit einem dicken Siliziumwafer,
ii. Oxidieren des Wafers auf mindestens einer ihrer zwei Flächen, um eine SiO₂-Schicht (17) zu bilden,
iii. Aufbringen einer piezoelektrischen Schicht auf der SiO₂-Schicht zwischen zwei Elektroden, um die Betätigungsmittel zu bilden,
iv. Ätzen der entstandenen Einheit, um ihr die Form des Resonators zu geben und um die Arme zu formen, wobei die Ätzung auf der Seite der Fläche, die nicht die piezoelektrische Schicht umfasst, angehalten wird, auf Ebene der Arme, um eine dünne Siliziumschicht zu bilden.
